# EUROPEAN PATENT APPLICATION

(11) **EP 0 996 162 A1**
(43) Date of publication of application: **26.04.2000**
(21) Application number: 98830628.8
(22) Date of filing: 21.10.1998
(51) Int. Cl.: H01L 27/115, H01L 21/8247

(54) **Low resistance contact structure for a select transistor of EEPROM memory cells**

(71) Applicant: STMicroelectronics S.r.l., 20041 Agrate Brianza (Milano) (IT)
(72) Inventor: Dalla Libera, Giovanna, 20052 Monza (Milano) (IT); Vajana, Bruno, 24100 Bergamo (IT)
(74) Representative: Mittler, Enrico

(57) **Abstract**

Semiconductor memory device, comprising at least one memory cells row, each memory cell comprising an information storing element (2) and a related select transistor (1) for selecting the storing element (2). The select transistor (1) comprises a gate oxide region (11) over a silicon substrate (14), a lower polysilicon layer (10) and an upper polysilicon layer (6) superimposed to the gate oxide region (11) and electrically insulated therebetween by an intermediate dielectric layer (9) interposed between them. The gate oxide regions (11) of the select transistors (1) of the at least one row are separated by field oxide regions (15), and the lower and upper polysilicon layers (10,6) and the intermediate dielectric layer (9) extend along the row over the gate oxide regions (11) of the select transistors (1) and over the field oxide regions (15). Along the row it is provided at least one opening in the upper polysilicon layer (6), intermediate dielectric layer (9) and lower polysilicon layer (10), inside of which a first contact element (20) suitable to electrically connect the lower and upper polysilicon layers (6,10) is inserted.

## Description

The present invention relates to a low resistance contact structure for a select transistor of EEPROM memory cells in a NO-DPCC process, i.e. without short-circuited double polysilicon.

In the present advanced process for manufacturing EEPROM memory devices it is quite difficult to obtain a good contact structure for the select transistor due to the high resistivity of the polysilicon layers constituting the transistor gates.

This difficulty is particularly present in the processes that do not provide short circuited double polysilicon (NO-DPCC) wherein the contact structure of the select transistor is obtained by means of complex process steps and expensive additional masks.

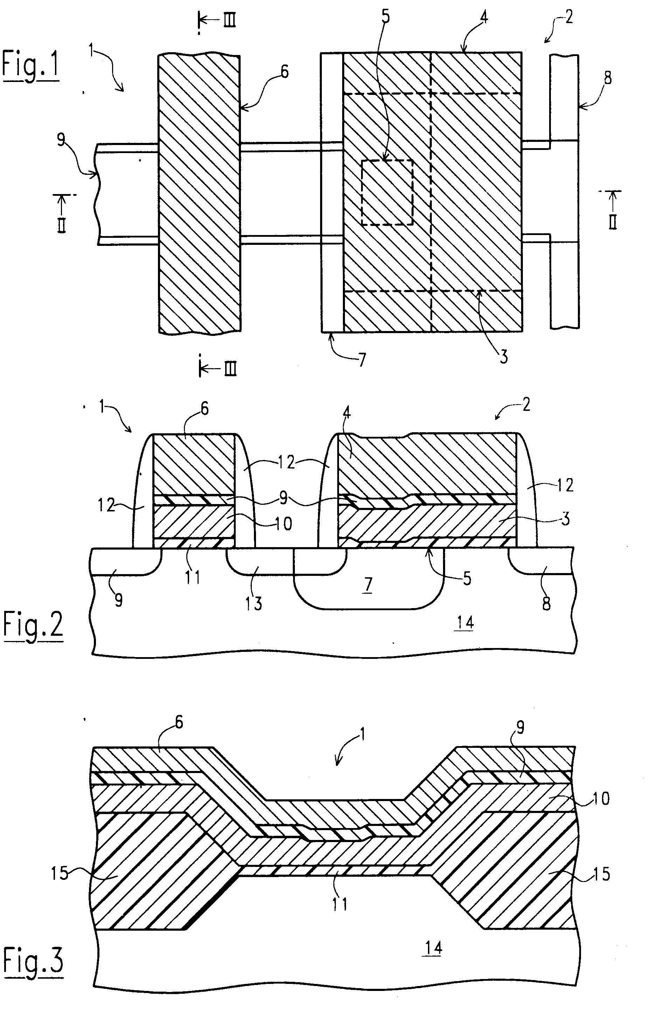

With reference to Figure 1, a plant view of the geometrical structure of a conventional EEPROM memory cell with its related select transistor is shown. The single memory cell is constituted by a select transistor 1, typical of non volatile EEPROM memories, connected in series to a storing transistor 2 wherein it can be noted a floating gate 3 (lower polysilicon) where the electrical charges are stored, a control gate 4 (upper polysilicon), a tunnel oxide area 5 (with a thickness of about 80 Å) through which the electrical charges pass, for Fowler-Nordheim effect, during the programming step. Moreover, it is present an area wherein an implant 7 is obtained (usually using phosphorous as dopant) with the purpose of keeping an electrical continuity between the select transistor 1 and the tunnel area 5.

In the memory cell it can be observed also drain regions 9 and source regions 8, and an upper polysilicon layer 6 of the select transistor 1, which forms a word line of the memory matrix.

Figure 2 shows a section view along line II-II of Figure 1. It can be noted the superimposed layers structure both of the select transistor 1 and of the storing transistor 2.

The select transistor provides a gate oxide layer 11 over a silicon substrate 14, a lower polysilicon layer 10 and the upper polysilicon layer 6 superimposed to it. An intermediate dielectric layer 9 is provided between the two layers, moreover present even between the two polysilicon layers 3 and 4 of the storing transistor, that usually is formed by oxide-nitride-oxide (ONO) and has the purpose to electrically insulate the two layers.

The select transistor 1 has the same structure of the storing transistor 2, i.e. lower polysilicon / intermediate dielectric / upper polysilicon, in order to preserve a planarity over the entire matrix.

Oxide spacers 12 are present at the sidewalls of the two transistors.

Between the two transistors connected in series a doped region 13 obtained in the silicon substrate 14 is provided, which is equivalent to a source region for the select transistor 1 and to a drain region for the storing memory 2. The doped region 13 is electrically connected to the implant region 7 to keep an electrical connection between the select transistor 1 and the tunnel area 5.

Figure 3 shows a section view along line III-III of Figure 1, wherein it is noted the select transistor 1 with the two polysilicon layers 6 and 10 electrically insulated by the intermediate dielectric 9, even on field oxide regions 15 (LOCOS), as a NO-DPCC process provides.

On the contrary, in a process providing short-circuited double polysilicon (DPCC) the lower polysilicon and the upper polysilicon are short-circuited on field oxide, using an appropriate mask in order to make possible to bias the select transistor gate by means of a contact on the upper polysilicon. Usually this occurs every 8 memory cells (1 byte).

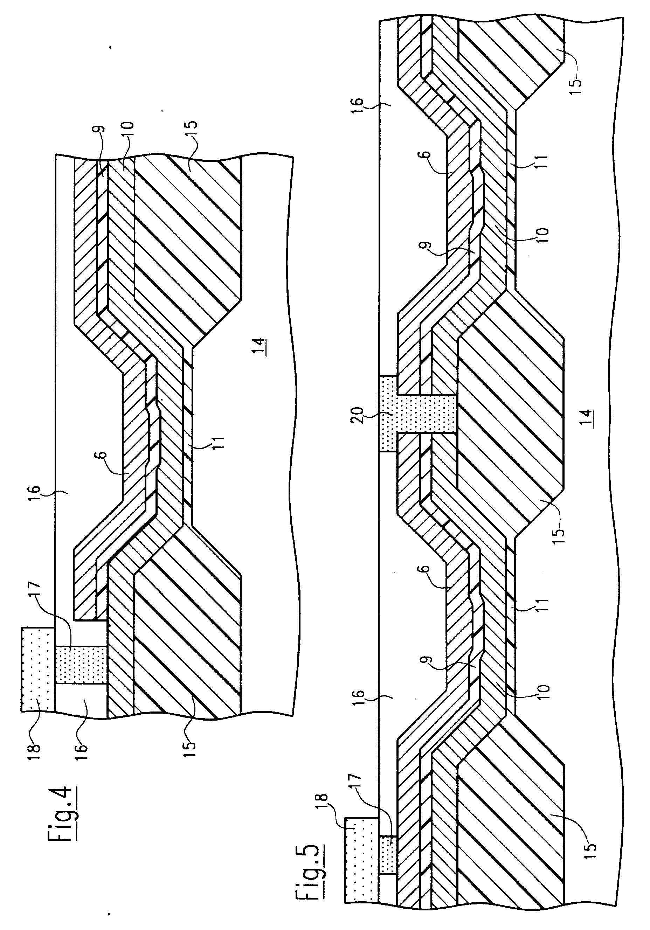

In a NO-DPCC process there are problems related to the definition of the contact to the select transistor. Figure 4 shows a section view, along a memory matrix row, of a select transistor obtained by means of a NO-DPCC process, wherein a contact on oxide field is present. The select transistor structure is analogous to that of Figure 3, and moreover it is present also an upper dielectric layer 16 over the entire device with the purpose of electrically insulating the polysilicon layers from possible superimposed metal layers. It is possible to observe the presence of a contact element 17 (for example constituted by tungsten) inserted in the upper dielectric layer 16 over the field oxide 15, with the purpose of connecting the lower polysilicon layer 10 with a metal line 18 in order to activate the select transistor gate.

The contact element 17 is connected to the lower polysilicon layer 10 rather than to the upper layer 6, typical in a DPCC process, just because the two polysilicon layers are electrically insulated, being manufactured by means of a NO-DPCC process.

The following problems are connected to such a contact structure: unlike a DPCC process, no short-circuiting between the lower polysilicon 10 and the upper polysilicon 6 is provided, and so it is necessary to introduce one or more masks for directly contacting the lower polysilicon 10 of the select transistor 1; normally, the lower polysilicon 10 has a high resistance and so the contact to the lower polysilicon 10 causes a problem of delay in the electrical signal propagation; the thickness of the lower polysilicon layer 10 is typically lower than that one of the upper polysilicon layer 6, and the process steps for defining polysilicon contacts can consequently cause problems of breaking down the lower polysilicon 10.

Then, in a NO-DPCC process that does not provide short-circuited double polysilicon, the manufacture of a contact structure for the select transistor becomes a very critical step.

In view of the state of the art described, it is an object of the present invention to provide a low resistance contact structure for a select transistor of EEPROM memory cells in a NO-DPCC process, that solves the above-mentioned problems.

According to the present invention, such object is achieved by means of a semiconductor memory device, comprising at least one memory cells row, each memory cell comprising an information storing element and a related select transistor for selecting the storing element, said select transistor comprising a gate oxide region over a silicon substrate, a lower polysilicon layer and an upper polysilicon layer superimposed to said gate oxide region and electrically insulated therebetween by an intermediate dielectric layer interposed between them, the gate oxide regions of the select transistors of said at least one row being separated by field oxide regions, said lower and upper polysilicon layers and said intermediate dielectric layer extending along said row over the gate oxide regions of the select transistors and over the field oxide regions, characterized in that along said row it is provided at least one opening in said upper polysilicon layer, intermediate dielectric layer and lower polysilicon layer, inside of which a first contact element suitable to electrically connect said lower and upper polysilicon layers is inserted.

The features and advantages of the present invention will be made more evident by the following detailed description of a particular embodiment thereof, illustrated as a non-limiting example in the annexed drawings, wherein:
Figure 1 shows a plant view of an EEPROM memory cell included a related select transistor, according to the prior art;
Figure 2 shows a section view along the line II-II of Figure 1;
Figure 3 shows a section view along the line III-III of Figure 1;
Figure 4 shows a section view of a select transistor and of a contact structure obtained by means of a NO-DPCC process, according to the prior art;
Figure 5 shows a section view, along a row of an EEPROM memory matrix, of two contiguous select transistors and of a contact structure, according to the present invention.

With reference to Figure 5, it can be observed that the two contiguous select transistors are structurally analogous to the transistor shown in Figure 4. However, in this case the contact element 17, inserted in the upper dielectric layer 16 over the field oxide 15, connects the metal line 18 with the upper polysilicon layer 6. The activation of the select transistors gate is anyway kept because it is present a further contact element 20, not connected to any metal line, which short-circuits the upper polysilicon layer 6 to the lower polysilicon layer 10 over the field oxide area 15, and simultaneously allows the electrical connection between the polysilicon layers 6 and 10 of the two contiguous select transistors.

To obtain a structure as described above, it is necessary to modify some manufacturing process steps, modifying or introducing manufacturing masks.

A typical DPCC process of manufacturing a memory device according to Figure 5 provides a first step of implantation, the definition of a tunnel area, the deposition of a lower polysilicon layer, and the definition of the floating gate by means of a proper selective etching. The process continues then with the growth of an intermediate dielectric layer, a selective etching of the intermediate dielectric and of the lower polysilicon in circuitry, the growth of gate oxide in circuitry, and the deposition of an upper polysilicon layer.

At this point the layout of the select transistor gates and of the storing transistor control gates is defined, and according to the present invention also a field oxide area (for example every 8 cells i.e. 1 byte) is formed, from which an upper polysilicon of the select transistor is removed, by means of a modified mask.

Subsequently, it is provided a consequent selective etching of the upper polysilicon, and then a self-aligned etching of the intermediate dielectric and of the lower polysilicon in the matrix for defining the select transistors gates and the memory cells control gates (circuitry is not etched). During this step the above-mentioned intermediate dielectric and lower polysilicon layers are etched also in the area previously defined on the field oxide and so the select transistor gates result to be interrupted over field oxide every n cells (for example every 8 cells).

The process continues then in a standard way, providing the deposition or growth of an upper dielectric layer over the entire device, up to the contact definition step. In this step it is used a contact mask comprising an opening in the previously defined field oxide area, wherein the select transistors line (word line) has been interrupted. The size of such an opening must be larger than that one of the underlying opening between the two polysilicon layers, in order not to have misalignment problems during the subsequent etching step.

At this point a selective etching is performed to define the contacts, removing the upper dielectric from all the contacts and arriving at the upper polysilicon, and moreover removing the upper dielectric from the without polysilicon area of the word line of the upper and lower polysilicon.

Thus, a conductive material (e.g. tungsten) is deposited to obtain contacts (plugs), which completely fills the contacts, short-circuits the lower and upper polysilicon layers of the select transistor at the opened area in the word line, and furthermore restores the electrical continuity of the select transistor gate. The process continues then in standard way up to the end.

In a different embodiment, the definition of the contact between the two polysilicon layers can be obtained in a different step; particularly, it can be made in a single step during the etching for the contact opening (so providing a single modified mask). In this case the etching turns out to be technologically more critical because it must be able to etch a sequence of different materials.

Thanks to such a contact structure, as shown in Figure 5, a short-circuit between the lower and the upper polysilicon 10 and 6 of the select transistor is obtained without adding any manufacturing mask to the conventional process flow. Moreover there is no delay in the word line signals propagation and no process complications of contacting the lower polysilicon because the contact to the select transistor occurs with a conventional contact on the upper polysilicon.

However it is necessary to pay attention to obtain a good polishing of the walls of the two polysilicon layers in the region wherein the short-circuit occurs, and moreover it is necessary an accurate calibration of the contact etching in order to avoid an excessive field oxide consumption in the contact region between lower and upper polysilicon.

## Claims

1. Semiconductor memory device, comprising at least one memory cells row, each memory cell comprising an information storing element (2) and a related select transistor (1) for selecting the storing element (2), said select transistor (1) comprising a gate oxide region (11) over a silicon substrate (14), a lower polysilicon layer (10) and an upper polysilicon layer (6) superimposed to said gate oxide region (11) and electrically insulated therebetween by an intermediate dielectric layer (9) interposed between them, the gate oxide regions (11) of the select transistors (1) of said at least one row being separated by field oxide regions (15), said lower and upper polysilicon layers (10,6) and said intermediate dielectric layer (9) extending along said row over the gate oxide regions (11) of the select transistors (1) and over the field oxide regions (15), characterized in that along said row it is provided at least one opening in said upper polysilicon layer (6), intermediate dielectric layer (9) and lower polysilicon layer (10), inside of which a first contact element (20) suitable to electrically connect said lower and upper polysilicon layers (6,10) is inserted.

2. Device according to claim 1, characterized in that said at least one opening is provided over at least one of said field oxide regions (15).

3. Device according to anyone of the preceding claims, characterized by comprising a second contact element (17) suitable to connect said upper polysilicon layer (6) to a metal line (18).

4. Device according to claim 3, characterized in that said first and second contact elements (20,17) are constituted by tungsten.

5. Device according to anyone of the claims 3 or 4, characterized by comprising an insulating material layer (16) superimposed to said upper polysilicon layer (6), said first and second contact elements (20,17) being inserted in it, and said metal line (18) being located over it.

6. Process of manufacturing a memory device according to claim 1, comprising the formation of said gate oxide regions (11) and of said field oxide regions (15) over said silicon substrate (14), and the formation of said lower polysilicon layer (10), intermediate dielectric layer (9) and upper polysilicon layer (6) over said gate oxide regions (11) and over said field oxide regions (15) in order to define said at least one row, characterized by providing for forming said at least one opening in said upper polysilicon layer (6), intermediate dielectric layer (9) and lower polysilicon layer (10), and for forming inside said at least one opening a related first contact element (20) suitable to electrically connect said upper polysilicon layer (6) with said lower polysilicon layer (10).

7. Process according to claim 6, characterized in that the formation of said at least one opening comprises, after the formation of said lower and upper polysilicon layers (10,6) and of said intermediate dielectric layer (9) and before the formation of said first contact element (20), a selective self-aligned etching of said upper polysilicon layer (6), intermediate dielectric layer (9) and lower polysilicon layer (10) in a region wherein said at least one opening is provided.

8. Process according to anyone of claims 6 or 7, characterized by comprising, after the formation of said at least one opening and before the formation of said first contact element (20), the formation of an insulating material layer (16) over said device and a selective etching of said insulating material layer (16) over said at least one opening.

9. Process according to claim 6, characterized by comprising, after the formation of said lower and upper polysilicon layers (10,6) and of said intermediate dielectric layer (9) and before the formation of said at least one opening, the formation of an insulating material layer (16) over said device and a selective etching of said insulating material layer (16), upper polysilicon layer (6), intermediate dielectric layer (9) and lower polysilicon layer (10) in a region wherein said at least one opening is provided.

10. Process according to anyone of claims 6 to 9, characterized in that said at least one opening is provided over at least one of said field oxide regions (15).

11. Process according to anyone of claims 6 to 10, characterized in that the formation of said first contact element (20) comprises a step of depositing a conductive material in said at least one opening.

12. Process according to claim 11, characterized in that said conductive material is tungsten.

13. Process according to anyone of claims 6 to 12, characterized by comprising the formation of a second contact element (17) and of a metal line (18), said second contact element (17) connecting said upper polysilicon layer (6) to said metal line (18).
